# EUROPEAN PATENT APPLICATION

(11) **EP 4 843 781 A1**
(43) Date of publication of application: **25.11.2026**
(21) Application number: 26175047.5
(22) Date of filing: 28.04.2026
(51) Int. Cl.: B41F 15/36, B41F 15/08, B41N 1/24, H05K 3/12

(54) **SIDE-LOADING TENSIONING FRAME**

(30) Priority: 21.05.2025 GB 202507910
(71) Applicant: ASMPT SMT Singapore Pte. Ltd., Singapore 768924 (SG)
(72) Inventor: EMERSON, Peter James, Weymouth, DT4 9TH (GB)
(74) Representative: Emerson, Peter James

(57) **Abstract**

A tensioning frame for tensioning a printing screen, comprising a plurality of elongate beams comprising a carriage movable relative to the beam body between an insertion position in which a printing screen may be inserted into the tensioning frame and an operative position in which the engagement projection may engage with the printing screen.

## Description

This invention relates to a tensioning frame for tensioning a printing screen, and a printing machine for printing print medium onto a workpiece via a printing screen.

### Background and Prior Art

Industrial screen-printing machines typically apply a conductive print medium, such as solder paste or conductive ink, onto a planar workpiece, such as a circuit board, by applying the conductive print medium through a pattern of apertures in a printing screen (sometimes referred to as a mask or stencil) using an angled blade or squeegee.

A printing screen is a substantially planar sheet which before use is cut to include apertures which define the pattern to be printed. In one common form it comprises a screen sheet formed of metal or plastics material, while in another common form comprises a mesh comprising a flexible, perforate sheet, for example a woven mesh of polypropylene or stainless steel strands. In both forms it is necessary to hold the printing screen under tension during a printing operation, and conventionally this is achieved by removably attaching the printing screen to a rectangular tensioning frame. There are various such tensioning frames and methods for providing engagement between a printing screen and a tensioning frame, with one well-known example being the VectorGuard (RTM) system, which is described in WO-2003093012-A1, WO-2005046994-A2, WO-2007091035-A1, WO-2009047012-A2 and GB-2526536-A. Other systems are described in, for example, US-5606911, US-5606912, US-5941171, US-6038969, US-6067903, US-6289804, WO-2017164493-A1, WO-2017188555-A1, WO-2019103284-A1.

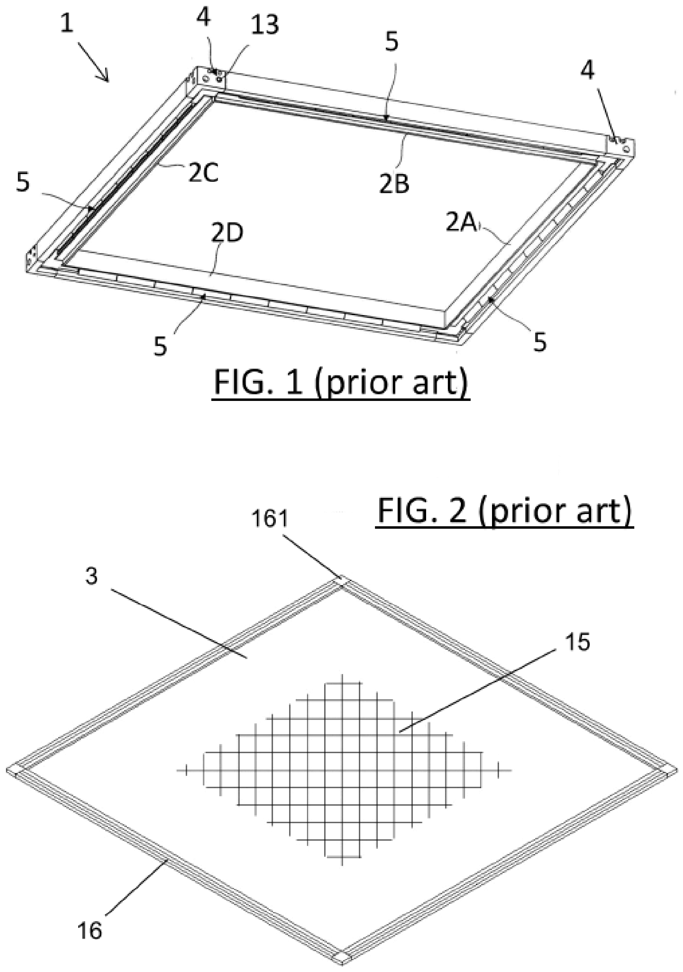

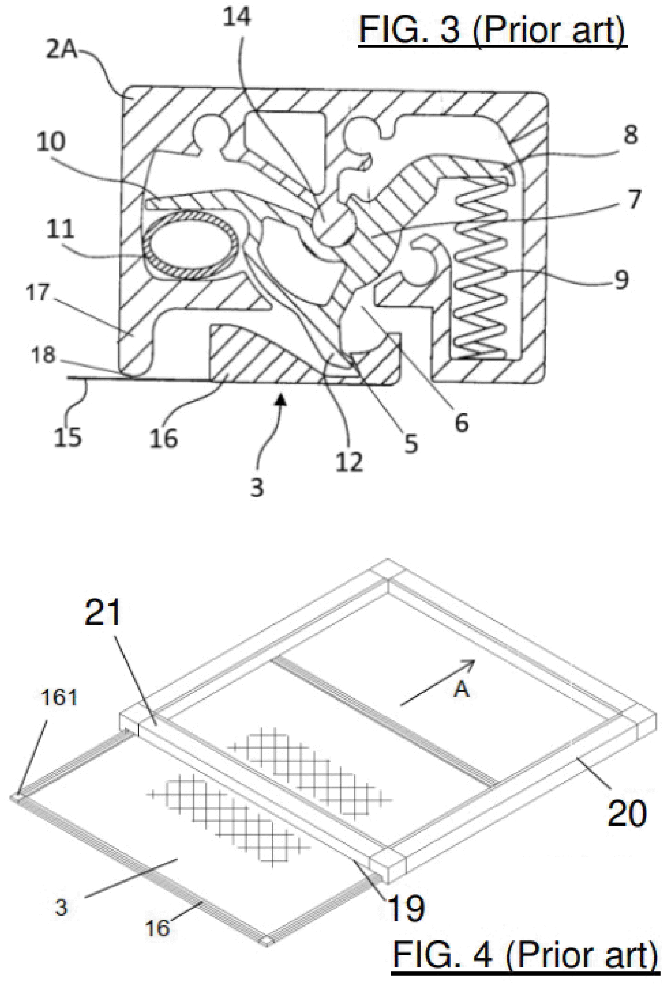

FIG. 1 schematically shows, in perspective view, the underside of a known VectorGuard tensioning frame 1, FIG. 2 schematically shows, in perspective view, a known printing screen 3 adapted for engagement with the VectorGuard tensioning frame 1 of FIG. 1, while FIG. 3 schematically shows a cross-section of a beam 2A of the VectorGuard tensioning frame in engagement with a printing screen 3. As can be seen from FIG. 1, the tensioning frame 1 is planar and defined by a plurality (here four) of elongate beams 2A-D which extend around the periphery of the tensioning frame 1, forming a rectangle, which in use may surround and tension a printing screen 3. The beams are identical in construction. Adjacent beams 2 are connected by corner pieces 4, one of which also includes a pneumatic port 13. Each beam includes a number of engagement surfaces 5, for engaging with a printing screen 3 in use. As can be seen in FIG. 1, the individual engagement surfaces 5 of each beam 2 are adjacent, and together form a composite engagement surface. With particular reference to FIG. 3, it can be seen that each beam (here beam 2A is shown) is hollow, comprising an elongate channel formed therein, the channel extending parallel to the length of the respective beam 2 and having an opening 6 at an engagement side (i.e. the underside) thereof, the engagement side of each beam 2 being co-planar and orientated parallel to the plane of the frame 1. The beam 2 is therefore approximately U-shaped in cross-section. Located within the channel is an engagement body 7 with three approximately radially-extending arms: a first arm 8 engages with a biasing member, here a spring 9, located between the arm 8 and an inner surface of the beam 2A; a second arm 10 which engages with a pneumatically inflatable tubing 11 located between the arm 10 and an inner surface of the beam 2A and which is connected to pneumatic port 13; and a third arm 12 carrying engagement surface 5. The engagement body 7 is mounted for rotation about a spindle 14 which is an integral part of the beam 2, with the rotation controlled by the inflation of tubing 11, acting against the bias of spring 9. The third arm 12 is sized so that the engagement surface 5 projects outwardly of the beam from the channel opening 6, during at least part of the engagement surface's range of travel during rotation of the engagement body. To tension a printing screen 3, the tubing 11 is first inflated to rotate the engagement body 7 clockwise as shown and thus move engagement surface 5 to the left as shown, and slightly retracted into the channel. A printing screen 3, which as shown in FIG. 2 has a patterned foil or mesh 15 and a supporting edging 16, which includes edging corner pieces 161, is then positioned proximate the underside of the frame 1. Pneumatic pressure is then released from tubing 11, which deflates, allowing the engagement body 7 to rotate anticlockwise as shown under the biasing force of spring 9, so that the engagement surface 5 moves to the right as shown, and slightly outwardly, to engage with a corresponding inclined profile of the edging 16, thus applying a tensioning force to the printing screen 3.

Each beam 2 includes a projection 17 located on the inner side, i.e. that side which faces the interior of the tensioning frame 1, which projects towards the printing screen 3 in use, i.e. downwardly as shown. The distal end of the projection 17 forms an abutment surface 18. When a printing screen 3 is located into the tensioning frame 1 and tension applied thereto by engagement of the engagement surfaces 5 and the edging 16, it can be seen that the rotary movement of the engagement surfaces 5 will cause the edging 16 to move both laterally away from the centre of the tensioning frame 1, thus increasing tension in the printing screen 3, and also slightly upwards towards the centre of the beams 2. This vertical movement causes the foil / mesh 15 to lift into contact with the abutment surface 18. It can be seen therefore that together, the abutment surfaces 18 of each beam 2 act as a bearing edge and define the plane of the tensioned foil / mesh 15 in use.

In practice, the VectorGuard tensioning frame is manufactured by forming each beam 2, and each engagement body 7, as metal extrusions. Each engagement body 7 may then be slid onto the spindle 14 from an end of the beam 2, and springs 9 and the tubing 11 are also inserted at one end of the beam 2 and slid along to the intended position.

The VectorGuard system in particular provides simple, consistent and reliable operation, leading to its widespread uptake in the industry.

However, a problem exists with such known apparatus in that it is difficult to automate the loading of a printing screen into the tensioning frame and subsequently into a printing machine.

Referring again to FIGs. 1 to 3, to load a printing screen 3 into the tensioning frame 1, the tensioning frame 1 may be placed upside down on a flat surface such as a table. Pneumatic pressure is applied to the tensioning frame 2 to inflate tubing 11 and thus retract the arm 12 into the channel. A printing screen 3 may then be placed onto the underside of the tensioning frame 1 and the pneumatic pressure turned off. The arm 12 may then move under the action of spring 9 to engage with the edging 16 of the printing screen 3 and tension the screen. This also serves to centre the printing screen 3 relative to the tensioning frame 1. The loaded tensioning frame 1 may then be turned right side up, and the loaded frame placed into a printing machine for use in a printing operation. The loading of the tensioning frame 1 therefore requires two separate inversions of the frame, together with an intermediate screen positioning step, followed by a separate machine loading step.

To this end, the present applicant developed a new form of tensioning frame, compatible with VectorGuard printing screens, which permits cartridge-style side-loading of printing screens into the tensioning frame. In this way, the printing screen may be loaded, for example manually or by a robot such as an autonomous intelligent vehicle, into a tensioning frame, without removing the frame from a printing machine, greatly streamlining the loading processes. As set out in WO 2021/094962 A1, this was achieved by providing a side opening 19 in a tensioning frame 20 to receive a printing screen, as schematically shown in FIG. 4. Here, the printing screen 3 is shown extending through the side opening 19 provided in a front beam 21 of the tensioning frame 20 during its loading in a direction A.

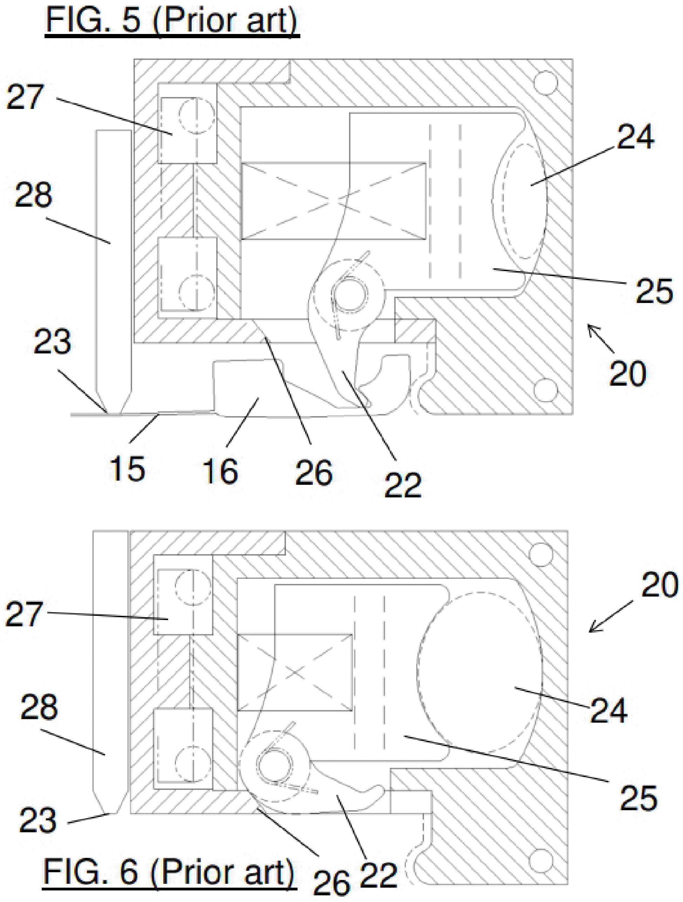

While this modification sounds trivial, in fact it is surprisingly difficult to implement. This is because there are various parts of the tensioning mechanism which may obstruct the loading of the printing screen 3. As described in WO 2021/094962 A1, to facilitate such side-loading, various components of the tensioning frame 20 are configured to move between engaged and loading positions, as schematically shown in FIGs. 5 and 6 respectively. In particular, it is necessary to move an engagement arm 22, which engages with the edging 16 of the printing screen 3 in use to apply a tensioning force thereto, and an abutment surface 23, which provides similar functionality to the abutment surface 18 shown in FIG. 3, i.e. providing a reliable tensioning plane for the foil 15 and blocking off the tensioning mechanism within the beam to prevent ingress of print medium (not shown) during a printing operation.

The tensioning frame 20 uses a pneumatic source to control operation. In particular, the engagement arm 22 is moved into the retracted position shown in FIG. 6 by pneumatically inflating a bladder 24 to push a shuttle 25 leftward as shown, which impels the engagement arm 22 into contact with a camming surface, which in turn causes the engagement arm 22 to rotate relative to the shuttle 25 and move upwardly, i.e. away from the vicinity of the printing screen 3. The abutment surface 23 meanwhile is moved vertically by a separate rotor 27, which is also pneumatically driven. In more detail, the abutment surface 23 is formed at the lower edge of a movable wall portion 28, and the movable wall portion 28 is drivable by the rotor 27 into a lowered configuration in which the abutment surface 23 contacts the foil 15, and a raised configuration in which it is positioned away from the vicinity of the printing screen 3.

That design is effective, however, for certain applications it is preferable to avoid pneumatic actuation. To that end, an alternative side-loading tensioning was developed, and which is described in WO 2024/201153A1. That design implemented a wholly mechanical actuation system, which may optionally be actuated manually, thus providing a particularly low-cost solution for customers. As an alternative, the frame may be actuated in an automated system, for example by an autonomous intelligent vehicle (AIV) or automated guided vehicle (AGV) equipped with a simple actuation tool.

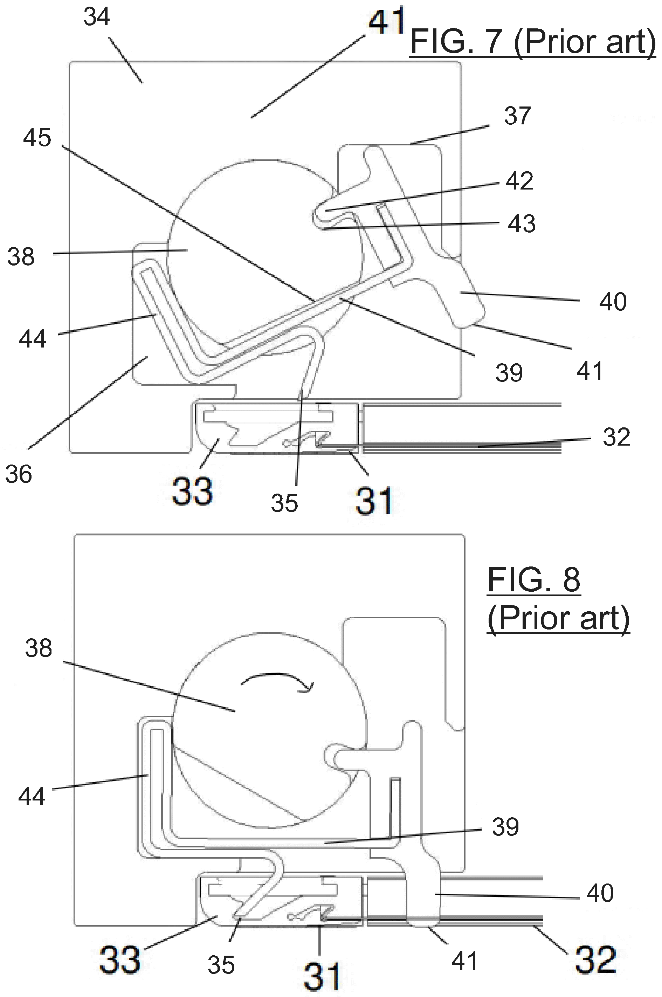

Key parts of this design are shown, in sectional side views, in FIGs. 7 and 8, in more detail a cross-section of a beam 34 of a tensioning frame. In FIG. 7, the tensioning mechanism is fully retracted, achieved by rotating an elongate shaft 38, which carries an engagement carriage 39 via a tongue 42 and slot 43 engagement, anticlockwise / counterclockwise as shown to its maximum extent, delimited by a movable wall portion 40 of the engagement carriage 39 abutting against a chamber wall 37 at an upper region of an internal chamber 36 of the beam 34. The movable wall portion 46 is thereby placed in its raised position, in fact the entire engagement carriage 39 is moved upwardly and rotated, while remaining held within the beam 34 by a leaf spring guide section 44 of the engagement carriage 39. This movement also causes an engagement projection 35 of the engagement carriage 39 to move upwardly to its retracted position. It can be seen that with the movable wall portion 40 in the raised position and the engagement projection 35 in the retracted position, a printing screen 31 can be inserted laterally into the tensioning frame without risk of collision with any part of the engagement carriage 39. It can also be seen that in this retracted position, the engagement carriage 39 is adjacent a chord surface 45 of the elongate shaft 38.

In FIG. 8, the tensioning mechanism has been moved into an engaged configuration, in which the engagement projection 35 is in its engagement position and applies a tensioning force to the printing screen 31 (to the left as shown), via profiled edging 33. In addition, an abutment surface 41, at the lower extent of movable wall portion 40, contacts the upper surface of a foil 32 of the printing screen 31 and presses downwardly into it, i.e. applying a downward force. This ensures a repeatably levelled surface for printing. The movable wall portion 40 is in its lowered position in which it at least partially closes the chamber 36, to prevent printing medium from fouling the tensioning mechanism.

However, for many applications and manufacturers, it is preferable to provide an actuation system which is not mechanical, but, for example, pneumatically or electrically driven, so that the printing screen may be tensioned without either direct operator or AGV interaction.

The present invention seeks to provide a side-loading tensioning frame which is suitable for such use cases.

### Summary of the Invention

In accordance with a first aspect of the present invention there is provided a tensioning frame for tensioning a printing screen, the tensioning frame being substantially planar and of rectangular shape, and comprising a plurality of elongate beams connected end to end to define the rectangular shape,
wherein each beam comprises:
a beam body, and
a carriage,
wherein the carriage comprises:
   an engagement projection moveable between a retracted position and an engagement position, the engagement projection configured to engage with a printing screen in use and apply a tensioning force thereto directed parallel to the plane of the tensioning frame as it moves from the retracted position to the engagement position, and
   an actuator operable to move the engagement projection in a direction parallel to the plane of the tensioning frame; and
   wherein the carriage is movable relative to the beam body along an axis orthogonal to the plane of the tensioning frame between an insertion position in which a printing screen may be inserted into the tensioning frame and an operative position in which the engagement projection may engage with the printing screen.

In accordance with a second aspect of the present invention there is provided a printing machine for printing print medium onto a workpiece via a printing screen, comprising:
a receptacle for receiving a tensioning frame of the first aspect in which an upper surface of the beam body comprises an opening to receive an external drive projection therethrough from above, such that passage of the external drive projection through the opening is operable to move the carriage to the operative position,
a downwardly extending drive projection, and
a drive means for vertically driving the drive projection,
configured such that in use the drive means drives the drive projection downwardly into the opening to move the carriage into the operative position.

Other specific aspects and features of the present invention are set out in the accompanying claims.

### Brief Description of the Drawings

The invention will now be described with reference to the accompanying drawings (not to scale), in which:
FIG. 1 schematically shows, in perspective view, the underside of a known tensioning frame;
FIG. 2 schematically shows, in perspective view, a known printing screen;
FIG. 3 schematically shows a cross-section of a beam of the tensioning frame of FIG. 1 in engagement with a printing screen;
FIG. 4 schematically shows, in perspective view from above, a known tensioning frame in a part-loaded configuration;
FIGs. 5 and 6 schematically show, in sectional side view, the tensioning frame of FIG. 4 in engaged and unloaded configurations respectively;
FIGs. 7 and 8 schematically show sectional side views of a beam of a known tensioning frame with its tensioning mechanism in a fully retracted configuration and a fully engaged configuration respectively;
FIG. 9 schematically shows, in perspective view from above, a tensioning frame in accordance with the present invention in a part-loaded configuration;
FIG. 10 schematically shows, in section, the tensioning frame of FIG. 9;
FIGs. 11A to 11C schematically show, in section, a beam of the tensioning frame of FIG. 9, showing stages in a transition from an insertion to an operative configuration;
FIG. 12 schematically shows, in section, another beam of the tensioning frame of FIG. 9;
FIGs. 13A and 13B schematically show, in section, a beam of a tensioning frame in accordance with another embodiment of the present invention, in insertion and operative configurations respectively;
FIGs. 14A and 14B schematically show, in section, a beam of a tensioning frame in accordance with a further embodiment of the present invention, in insertion and operative configurations respectively; and
FIG. 15 schematically shows, in isometric view from above, a printing machine in accordance with the present invention.

The components in the figures are not necessarily to scale, emphasis instead being placed upon illustrating various preferred embodiments of the invention. The figures are provided with Cartesian axes for ease of understanding. The Z axis shown in each case extends vertically upwards, while the X and Y axes lie in the horizontal plane, which corresponds to the most common use cases of the apparatus described. Where possible, reference numerals are retained for similar components.

### Detailed Description of the Preferred Embodiments of the Invention

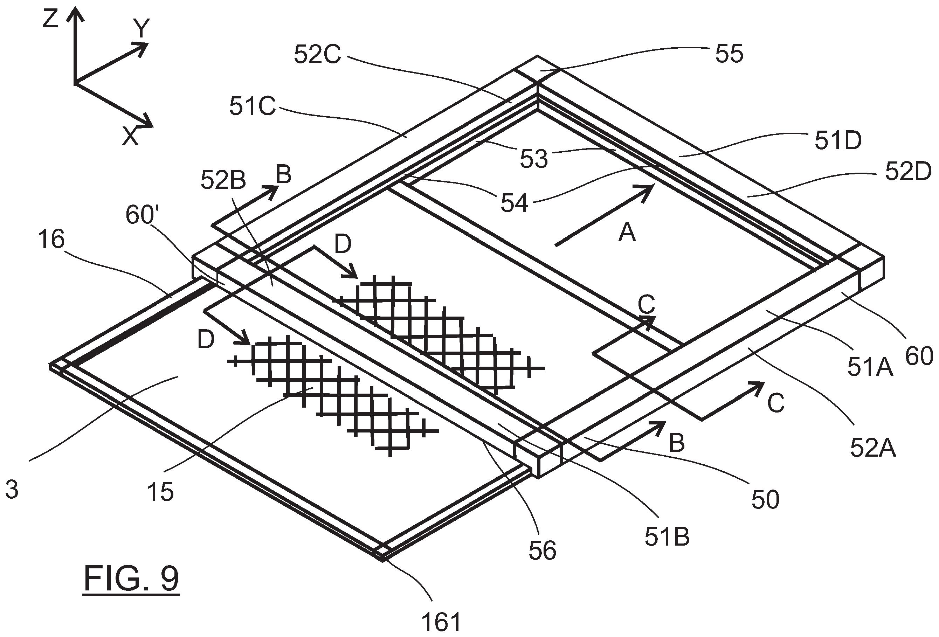

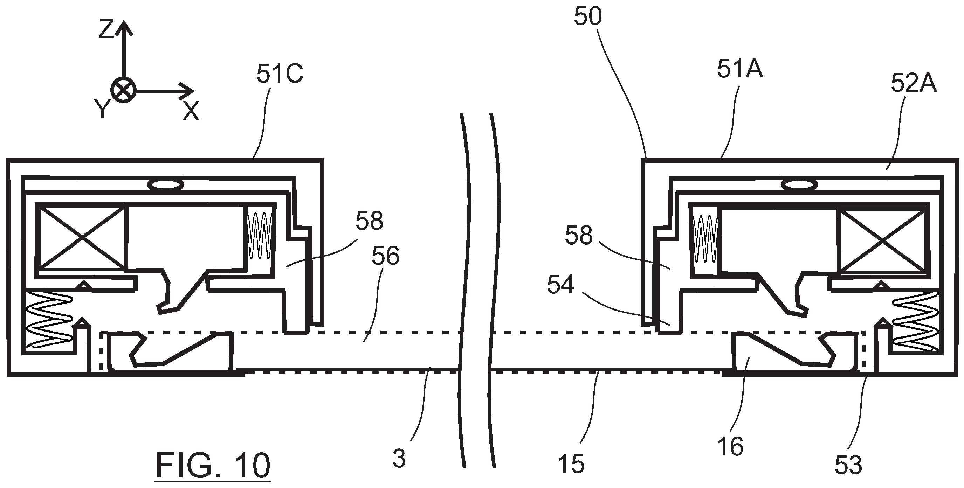

A tensioning frame 50 in accordance with the present invention is schematically shown in FIG. 9, in a partially loaded configuration, similar to FIG. 4 described above. A printing screen 3 is shown partially inserted into the tensioning frame 50, and for convenience the printing screen 3 is shown as being identical to that of FIG. 4. The tensioning frame 50 is substantially planar (i.e. in the X-Y plane shown) and of rectangular shape, and comprises a plurality of elongate beams 51A-D connected end to end to define the rectangular shape. In more detail, the beams 51A-D are connected via respective frame corner pieces 55, which, similarly to the conventional VectorGuard frame shown in FIG. 1, engage with a pair of respective adjacent beams in a modular manner, so as to simplify construction, as will be explained in more detail below. As will be described in more detail below, each beam 51A-D comprises two relative movable components. The first of these is a beam body 52A-D, which is a rigid elongate member, for example formed from extruded aluminium, steel or the like, with a hollow interior which constitutes a chamber (57, see FIG. 10A for example). Each beam body 52A-D comprises an outer wall 60 which defines an outer edge of the tensioning frame 50 which delimits the lateral extent of the tensioning frame 50 parallel to its plane. Each beam body 52A-D also forms the upper surface of the tensioning frame 50. At a base portion of each beam body 52A-D is a shelf 53, which projects inwardly (i.e. towards the centre of the tensioning frame 50), and on which the printing screen 3 may be supported. In more detail, the edgings 16 of the printing screen 3 may be directly supported on the shelf 53. Located at least partially within the chamber 57 is the other component, namely a carriage (58, see FIG. 10A for example). The carriage 58 is movable relative to the respective beam body 52A-D along an axis orthogonal to the plane of the tensioning frame 50 between an insertion position in which a printing screen 3 may be inserted into the tensioning frame 50 and an operative position in which an engagement projection 67 (see below) may engage with the printing screen 3.

In FIG. 9, only a part of the carriage 58 is visible, namely a skirt 54, which projects downwardly from the carriage 58 and is substantially as long as its respective beam 51A-D. As shown, one beam 51B is provided with a slot 56 in an outer wall 60', dimensioned so as to permit the printing screen 3 to be received therethrough for loading and unloading. The slot 56 will also extend to the frame corner pieces 55 adjacent to beam 51B. The slot is arranged above the shelf 53, so that the printing screen is supported by the shelf 53 as it is received through the slot 56.

FIG. 10 schematically shows, in section taken in the direction B-B shown in FIG. 9, the tensioning frame 50 of FIG. 9. By way of explanation, slot 56, formed in beam 52B, is also illustrated in dashed lines, since it would not otherwise be visible in this section. The tensioning frame 50 is shown in an "insertion configuration", in which the carriages 58 of all beams are at their highest vertical (+ve Z) position relative to the beam bodies 52A-E. In this position, it can be seen that not part of the carriages 58 are located in line with the slot 56. This means that, in the insertion configuration, a printing screen 3 may be inserted into the tensioning frame 50 via the slot 56, so that it is entirely located within the horizontal footprint of the tensioning frame 50, without risk of collision with any components of the tensioning frame 50. It will be apparent that the minimum possible vertical extent of the slot 56 will be slightly larger than the vertical extent of edgings 16, which are the thickest parts of the printing screen 3. The shelf 53 of each beam lies below the lowest extent of the slot 56, so that the printing screen 3 may slide along the shelf 53 as it is moved into the fully-loaded position. The shelf 53 may be directly attached to the beam body 52A, or formed integrally therewith. The internal configuration of beam 51A, and its functioning, are described in more detail below.

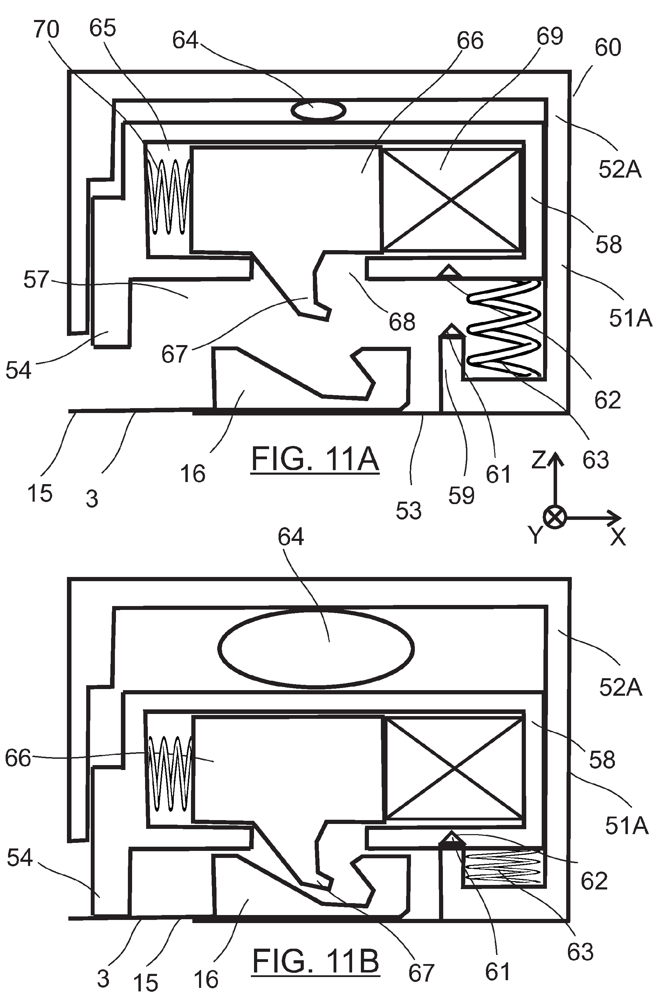

FIGs. 11A to 11C schematically show, in section taken in the direction C-C shown in FIG. 9, a beam 51A of the tensioning frame 50 of FIG. 9, showing stages in a transition from the insertion configuration to an operative configuration.

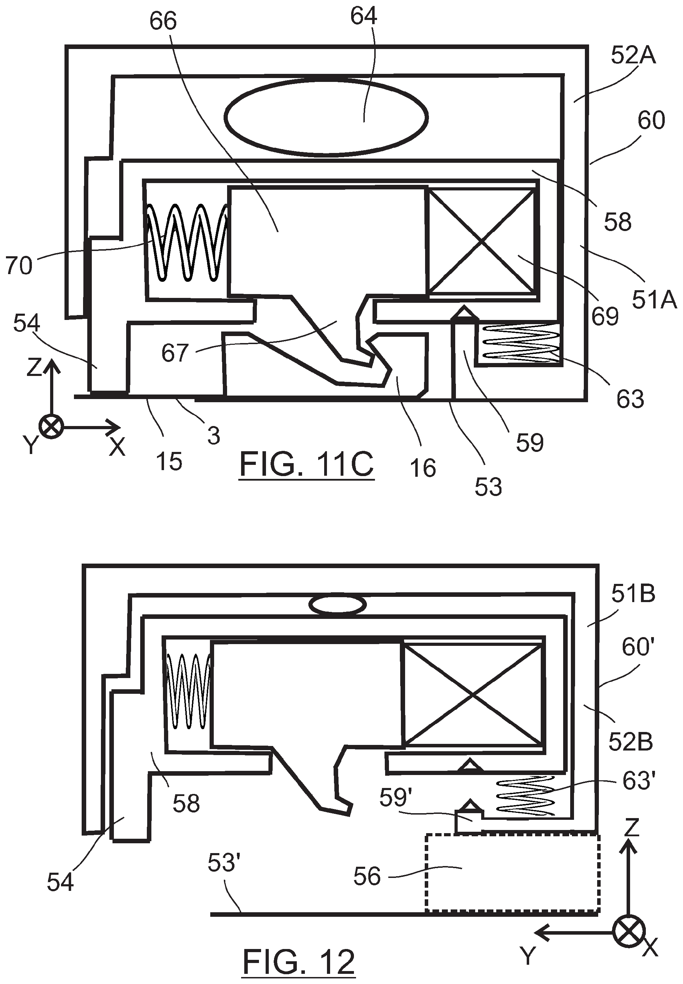

In FIG. 11A (which effectively presents a magnified view of part of FIG. 10) the tensioning frame 50 is in the insertion configuration. In this view, the main components can be seen more clearly. In particular, it can be seen that the beam body 52A comprises a hollow interior forming chamber 57, in which the carriage 58 may slide up and down, i.e. relative to the beam body 52A. Lateral movement of the carriage 58, i.e. in a direction parallel to the X axis in this case, is loosely constrained by the internal sides of the beam body 52A, so as to permit the sliding movement while preventing excessive rotation of the carriage 58 within the chamber 57, i.e. about an axis parallel with the Y axis shown. As will be described in more detail below, a lower centring projection 61 pointing upwardly from an upstanding wall 59 (which projects upwardly from the base of the beam body 52A) and an associated upper centring recess 62 provided in the underside of the carriage 58, provide additional lateral constraint to the carriage 58 when in the operative configuration. The lower centring projection 61 may conveniently be formed as a ridge running the length of the beam 51A, with the upper centring recess 52 formed as a corresponding groove running the length of the beam 51A. The carriage 58 is biased towards the top of the chamber 57 by a biasing means, in this case a compression spring 63 located between the base of the beam body 52A and the underside of the carriage 58. Other forms of biasing means, such as leaf springs, whether placed in this location or at different parts of the beam 51A, are equally possible in other embodiments (not shown). A pneumatic actuator, in this case a pneumatically-inflatable bladder 64, is interposed between the upper surface of the carriage 58 and the beam body 52A, which runs along the length of the beam body 52A (i.e. parallel to the Y axis). In this insertion configuration, the bladder 64 is deflated. As previously mentioned, the carriage 58 carries a skirt 54, which depends downwardly therefrom, at the lateral side of the carriage 58 (in this case the left side as shown) which is closest to the centre of the tensioning frame 50. The skirt 54 is dimensioned such that, in the insertion configuration, it is located entirely above the slot 56 to avoid collision with a printing screen being inserted, while, as shown below in FIG. 11B and 11C, in the operative configuration, the lowest extent of the skirt 54 presses down into the upper surface of the foil 15 of the loaded printing screen 3. The skirt 54 is substantially as long as the beam 51A, and in use partitions a central, patterned region of the printing screen 3 from the engagement projection 67 (see below). The carriage 58 comprises an internal bore 65, which houses a shuttle 66 which is slidably movable within the bore 65, in a direction parallel to the X axis as shown. The shuttle 66 comprises an engagement projection 67 which projects downwardly therefrom, and takes the general form of a hook. This is dimensioned so as to engage, in use, with the edging 16 of a printing screen 3. The engagement projection 67 protrudes through an aperture 68 at the lower side of the bore 65. An actuator 69 is also located in the bore 65, here on the side of the shuttle 66 distal from the centre of the tensioning frame 50, and which is configured to drive the shuttle 66, and hence the engagement projection 67, towards the centre of the tensioning frame 50, i.e. to the left as shown. A biasing means, here a compression spring 70, is provided in the bore 65 distal to the actuator 69 so as to provide a biasing force to the shuttle 66, and hence the engagement projection 67, away from the centre of the tensioning frame 50, i.e. to the right as shown. For the avoidance of doubt, when the actuator 69 is activated, the shuttle 66 is driven to the left against the biasing force of compression spring 70 into a retracted position a shown, and when the actuator 69 is deactivated, the drive force is released and the compression spring 70 acts to drive the shuttle, and hence the engagement projection 67, to the right, into an engagement position as shown in FIG. 11C. In the insertion configuration shown in FIG. 11A, the actuator 69 is activated, so the shuttle 66 is at its leftmost possible position, i.e. the retracted position. The actuator 69 may take various forms, which is why it has been shown as a generic component in FIG. 11. It may for example comprise a pneumatically-actuable bladder, such as bladder 24 shown in FIGs. 5 and 6, or comprise a pneumatically-actuated piston, or alternatively an electrically-actuated linear drive, all of which are well-known engineering options to produce linear motion. If a pneumatic bladder is used, this may run along the length of the beam 51A, and receive pneumatic supply via a termination at a frame corner piece 55, similarly to the traditional VectorGuard frame shown in FIGs. 1 and 3, and the bladder 64 may be similarly constructed and pneumatically supplied. In the case of pneumatic pistons, a plurality of such pistons may be arranged along the length of the beam 51A, each piston housed in a respective bore to engage with a respective shuttle. The pistons may be pneumatically supplied via tubing located in the space between the top of the carriage 58 and the beam body 52A for example. Electrical actuators may be similarly arranged along the length of the beam 51A, and electrically supplied by using wires provided in the same space for example. For example, as can be seen in FIG. 11A, even in the insertion configuration in which the carriage 58 is at its highest position, there remains space between the top of the carriage 58 and the beam body 52A which may be used to house flexible pneumatic and / or electrical lines, which may terminate at a frame corner piece 55. Alternatively, electrical power may be supplied by provided brush contacts between the carriage 58 and the beam body 52A, for example at the rightmost lateral side of the carriage 58 as shown. In any case, such operative connections for the actuator 69 and bladder 64 are omitted for clarity. However, those skilled in the art will recognise that there are many ways in which pneumatic and / or electrical power can be provided to these components.

All of beams 51A, 51C and 51D may take similar forms. However, beam 51B is provided with the slot 56, and so will be formed differently. In particular, it can be seen that the compression spring 63 and upstanding wall 59 could form a barrier to insertion of a printing screen 3 through the slot 56, and so an alternative construction is required. This is described in more details with respect to FIG. 12 below.

FIG. 11B shows the beam 51A of FIG. 11A in a transitional state between the insertion and operative configurations. This state is achieved by pneumatically inflating the bladder 64, so as to move the carriage 58 downwards within the chamber 57, against the biasing force provided by the compression spring 63, into an "operative position" in which the engagement projection 67 may engage with the printing screen 3. The skirt 54 is thereby brought into firm abutting contact with the foil 15. In this state, the shuttle 66 remains in its retracted position, so that it may enter the recess at the top side of the wedging 16 without collision. It can be seen that the lower centring projection 61 and upper centring recess are brought into engagement, which acts to restrain the carriage 58 in a desired lateral position within the chamber 57.

FIG. 11C shows the beam 51A of FIGs. 11A, 11B in the operative configuration. The bladder 64 remains inflated, so that the carriage 58 remains at its lowest, operative, position. The actuator 69 is deactivated, so that the shuttle 66, and hence the engagement projection 67, are pushed from the retracted position to the engagement position away from the centre of the tensioning frame 50 by the compression spring 70. The engagement projection 67 thereby engages with the edging 16 of the printing screen 3 and applies a tensioning force thereto. The printing screen 3 is now ready for use in a printing operation within a printing machine. It should be noted that the abutment of the skirt 54 with the foil 15 in use partitions a central, patterned region of the printing screen 3 from the engagement projection 67, and is required for various reasons, including forming a barrier to prevent print medium, such as solder paste, from fouling the tensioning mechanism during a printing operation, so ensure required planarity of the foil 15, and to promote even tensioning of the foil 15.

A printing screen loading sequence may therefore be summarised as follows:
i) The tensioning frame 50 is placed into the insertion configuration, with the bladder 64 deflated and the actuator 69 activated to move the shuttle 66 to its retracted position;
ii) A printing screen 3 is laterally slid into the tensioning frame 50 through the slot 56 in beam 51B, until it is fully inserted;
iii) The bladder 64 is inflated, moving the carriage to its operative position; and
iv) The actuator 69 is deactivated, so that the compression spring 70 pushes the shuttle 66 to its engagement position.

Following use, the printing screen 3 may be unloaded by reversing these steps, i.e.:
v) Activating the actuator 69 to move the shuttle 66 to its retracted position;
vi) Deflating the bladder 64, so that the carriage 58 returns to its insertion position; and
vii) Removing the printing screen 3 back through the slot 56.

Although steps ii) and iv) (and also v) and vi)) are preferably performed sequentially, in other embodiments these are performed at least partially simultaneously.

It is important to note that the bladder 64, and the actuator 69, of each beam 51A-D is actuated simultaneously, so that the carriages 58 and shuttles 66 of each beam 51A-D are moved in concert. To assist this concerted movement, in some embodiments the carriages 58 of each beam 51A-D may be fixedly connected together, to form a single unit.

FIG. 12 schematically shows, in section along the line D-D of FIG. 9, beam 51B of the tensioning frame 50. Although it shares many similarities with the other beams 51A, C and D, (for example the carriage 58 is identical to those of the other beams) there are a number of modifications, necessitated by the inclusion of the slot 56 passing through the beam. For clarity, modified components are provided with a " ' " suffixed to their normal reference numerals. In particular, the beam body 52B has a slightly different section, so that the outer wall 60' has a smaller vertical extent. Similarly, upstanding wall 59' is shortened in consequence. These changes also require a slightly shorter compression spring 63' to fit into the available space between the underside of the carriage 58 and the beam body 52B. It is apparent that, due to the presence of the slot 56, it is not possible to attach shelf 53' directly to the beam body 52B. Instead, shelf 53' comprises a separate, elongate member that is attached at each end to a lower surface of the adjacent frame corner pieces 55, so that it bridges across the beam 51B.

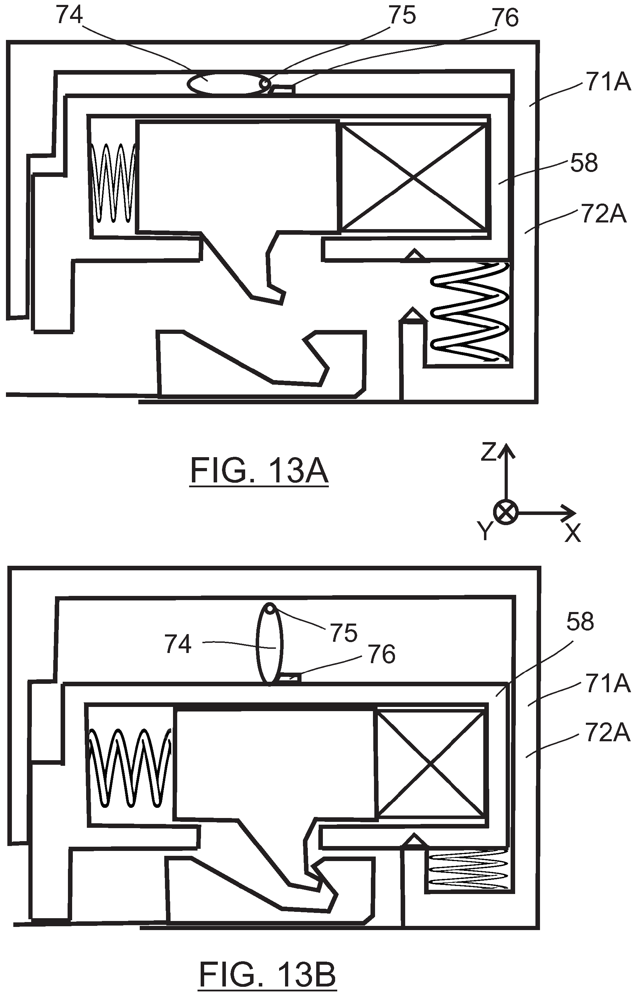

FIGs. 13A and 13B schematically show, in section, a beam 71A of a tensioning frame in accordance with another embodiment of the present invention, in insertion and operative configurations respectively. Beam 71A is very similar to beam 51A shown in FIGs 11A-C, and so need not be described again in detail. However, in this embodiment, pneumatic bladder 64 is replaced by a rotatable cam 74. From the insertion configuration shown in FIG. 13A, the cam 74 may be rotated anti / counterclockwise as shown, which forces carriage 58 downwards to its operative position. A stop member 75 is provided on the topside of the carriage 58, in a position to contact the cam 74 when the carriage reaches the operative position. This stop member 75 not only prevents further rotation of the cam 74, but also provide further lateral locking of the carriage 58 within the chamber 57, causing the carriage 58 to be impelled towards the right as shown.

The cam 74 is driven by a shaft 76 extending the length of the beam 71A. The cam 74 may thus be operated by rotating the shaft 76. All of the shafts 76 (i.e. the shafts of each beam) may be mechanically connected, via bevel gears or the like, to ensure that the respective cams 74 are all rotated in concert. Alternatively, if the carriages 58 are fixed together as a single unit, then such cams 74 may only be required on one or two of the beams, for example the beams 71A, 71C located adjacent the slotted beam 71B. Rotation of the cams 74 may thus be achieved in various ways, for example by mechanically connecting a manually-operable lever to the cam (or cams) 74 via each respective shaft 76. This may conveniently be achieved by, for example, extending the shaft 76 out of the outer wall of slotted beam 71B and connecting a manually-operable lever thereto. There are various ways in which a lever or levers may be fitted to the tensioning frame, for example WO 2024/201153A1 (see FIG. 18 in particular) illustrates a similar mechanism. Alternatively, the shaft or shafts 76 may be rotated by an end effector of a mobile robot, for example while the tensioning frame is located within a printing machine. The same mobile robot may be used to insert a printing screen 3 into the tensioning frame also. Such a configuration is especially beneficial as it permits a high level of automation for screen changeovers.

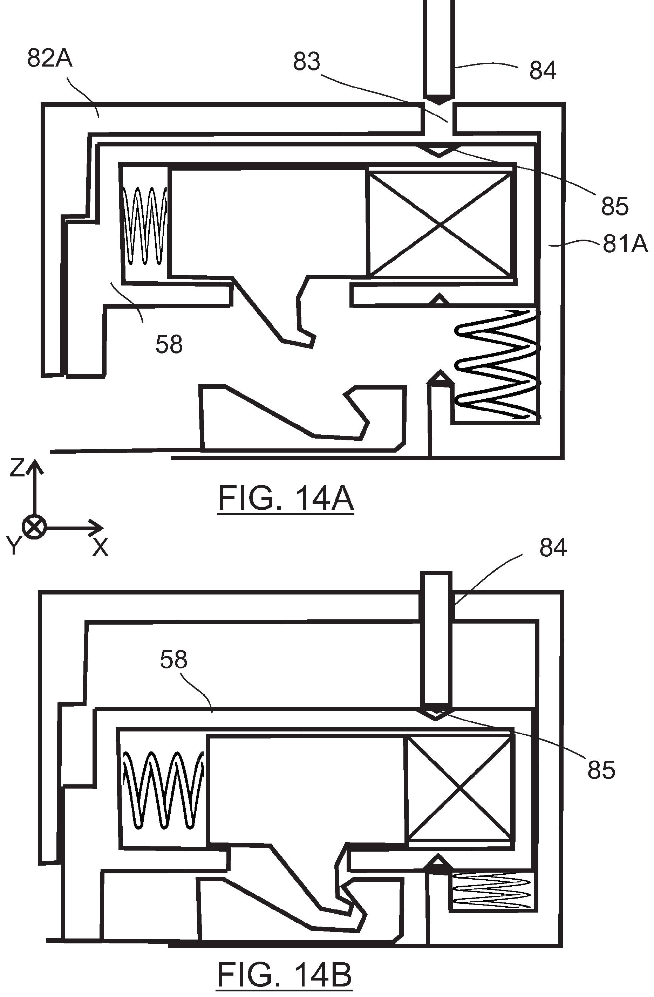

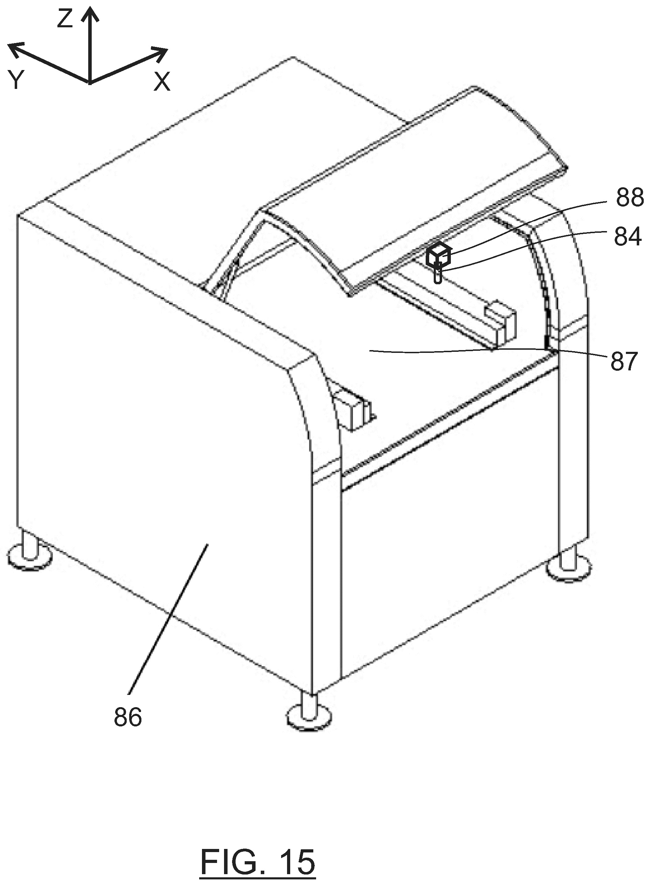

FIGs. 14A and 14B schematically show, in section, a beam 81A of a tensioning frame in accordance with a further embodiment of the present invention, in insertion and operative configurations respectively, while FIG. 15 shows a printing machine equipped to operate such a tensioning frame. Beam 81A is very similar to beam 51A shown in FIGs 11A-C, and so need not be described again in detail. In this embodiment, movement of the carriage 58 from the insertion position to the operative position is effected by an external drive projection 84 external to the tensioning frame. The beam body 82A is provided with an opening 83 in an upper surface thereof, sized so as to receive the external drive projection 84, which may take the form or a rod or pole for example. Preferably, and as shown, the external drive projection 84 comprises centring means, such as a conical surface, at its lower end, and an upper surface of the carriage 58 is provided with corresponding centring means, such as a conical recess 85, directly below the opening 83. Insertion of the external drive projection 84 through the opening 83 proceeds such that the respective centring means engage, and continues until the carriage 58 is pushed to the engagement position. The external drive projection 84 remains in that position until it is desired to unload the printing screen.

Referring now to FIG. 15, the external drive projection 84 may depend downwardly from a part 88 of a printing machine 86, such as a clamp or chase of the printing machine 86. In this way, movement of the carriage 58 to the operative position may be achieved simultaneously with clamping of the tensioning frame within a receptacle 87 of the printing machine 86.

The above-described embodiments are exemplary only, and other possibilities and alternatives within the scope of the invention will be apparent to those skilled in the art. For example, the shelves 53 of the beams 51A, 51C, 51D could be similarly constructed to shelf 53' shown in FIG. 12, i.e. separate to the beam body of the respective beam, and instead attached to adjacent frame corner pieces.

### Reference numerals used:

1 - Tensioning frame
2, 2A-D - Beams
3 - Printing screen
4 - Corner pieces
5 - Engagement surfaces
6 - Opening
7 - Engagement body
8 - First arm
9 - Spring
10 - Second arm
11 - Inflatable tubing
12 - Third arm
13 - Pneumatic port
14 - Spindle
15 - Foil / mesh
16 - Edging
161 - Edging corner pieces
17 - Projection
18 - Abutment surface
19 - Side opening
20 - Tensioning frame
21 - Front beam
22 - Engagement arm
23 - Abutment surface
24 - Bladder
25 - Shuttle
26 - Camming surface
27 - Rotor
28 - Movable wall portion
34 - Beam
35 - Engagement projection
36 - Chamber
37 - Chamber wall
38 - Elongate shaft
39 - Engagement carriage
40 - Movable wall portion
41 - Abutment surface
42 - Tongue
43 - Slot
44 - Leaf spring guide section
45 - Chord surface
50 - Tensioning frame
51A-D - Beams
52A-D - Beam bodies
53, 53' - Shelf
54 - Skirt
55 - Frame corner pieces
56 - Slot
57 - Chamber
58 - Carriage
59, 59' - Upstanding walls
60, 60' - Outer walls
61 - Lower centring projection
62 - Upper centring recess
63, 63' - Compression springs
64 - Bladder
65 - Bore
66 - Shuttle
67 - Engagement projection
68 - Aperture
69 - Actuator
70 - Compression spring
71A - Beam
72A - Beam body
74 - Cam
75 - Stop member
76 - Shaft
81A - Beam
83 - Opening
84 - External drive projection
85 - Centring means
86 - Printing machine
87 - Receptacle
88 - Part

## Claims

1. A tensioning frame for tensioning a printing screen, the tensioning frame being substantially planar and of rectangular shape, and comprising a plurality of elongate beams connected end to end to define the rectangular shape,
wherein each beam comprises:
a beam body, and
a carriage,
wherein the carriage comprises:
an engagement projection moveable between a retracted position and an engagement position, the engagement projection configured to engage with a printing screen in use and apply a tensioning force thereto directed parallel to the plane of the tensioning frame as it moves from the retracted position to the engagement position, and
an actuator operable to move the engagement projection in a direction parallel to the plane of the tensioning frame; and
wherein the carriage is movable relative to the beam body along an axis orthogonal to the plane of the tensioning frame between an insertion position in which a printing screen may be inserted into the tensioning frame and an operative position in which the engagement projection may engage with the printing screen.

2. The tensioning frame of claim 1, wherein the beam body comprises an outer wall which defines an outer edge of the tensioning frame which delimits the lateral extent of the tensioning frame parallel to the plane; optionally at least one beam body comprises a slot formed in the outer wall, dimensioned so as to permit a printing screen to be received therethrough when the carriage is in the insertion position.

3. The tensioning frame of any preceding claim, wherein the beam body has a hollow interior which constitutes a chamber, and the carriage is slidably moveable within the chamber.

4. The tensioning frame of any preceding claim, wherein the carriage comprises a downwardly projecting skirt which is configured to abut an upper surface of a printing screen in use when the carriage is in the operative position; optionally the skirt is substantially as long as the beam, and in use partitions a central, patterned region of the printing screen from the engagement projection.

5. The tensioning frame of any preceding claim, wherein the carriages of each beam are fixed to constitute a single unit.

6. The tensioning frame of any preceding claim, wherein a base portion of the beam body comprises a shelf configured to support a printing screen thereon.

7. The tensioning frame of any preceding claim, wherein the carriage comprises biasing means to bias the engagement projection to the engagement position, and the carriage further comprises an actuator configured to selectively drive the engagement projection to the retracted position; optionally the actuator comprises a pneumatic actuator, optionally the pneumatic actuator comprises a piston or a bladder.

8. The tensioning frame of any preceding claim, wherein the beam comprises biasing means to bias the carriage to the insertion position.

9. The tensioning frame of any preceding claim, wherein the beam comprises a cam member disposed between the beam body and the carriage, the cam being operable to move the carriage to the operative position; optionally the cam member acts to lock the position of the carriage relative to the beam body in a direction parallel to the plane of the tensioning frame.

10. The tensioning frame of claim 9, comprising a manually-operable lever mechanically connected to the cam member.

11. The tensioning frame of any of claims 1 to 8, wherein the beam comprises a pneumatic actuator, optionally a bladder, disposed between the carriage and the beam body, operable to drive the carriage to the operative position.

12. The tensioning frame of any of claims 1 to 8, wherein an upper surface of the beam body comprises an opening to receive an external drive projection therethrough from above, such that passage of the external drive projection through the opening is operable to move the carriage to the operative position; optionally the carriage comprises an engagement surface to engage with the drive projection in use and lock the position of the carriage relative to the beam body parallel to the plane of the tensioning frame.

13. The tensioning frame of any preceding claim, wherein the beam body and the carriage comprise mating engagement surfaces arranged to mate when the carriage is in the operative position and thereby lock the position of the carriage relative to the beam body parallel to the plane of the tensioning frame.

14. A printing machine for printing print medium onto a workpiece via a printing screen, comprising:
a receptacle for receiving the tensioning frame of claim 12,
a downwardly extending drive projection, and
a drive means for vertically driving the drive projection,
configured such that in use the drive means drives the drive projection downwardly into the opening to move the carriage into the operative position.

15. The printing machine of claim 14, wherein the drive projection comprises centring surfaces to engage with the carriage and lock the position of the carriage relative to the beam body parallel to the plane of the tensioning frame.
